# EUROPEAN PATENT SPECIFICATION

(11) **EP 3 095 186 B1**
(45) Date of publication and mention of the grant of the patent: **05.06.2019**
(21) Application number: 14718197.8
(22) Date of filing: 14.01.2014
(51) Int. Cl.: H03F 1/02, H03F 1/42, H03F 3/24, H03F 3/60

(54) **DOHERTY AMPLIFIER WITH A WIDEBAND IN-PHASE POWER COMBINER**
DOHERTY-VERSTÄRKER MIT EINEM BREITBANDIGEN PHASENINTERNEN LEISTUNGSKOMBINIERER
AMPLIFICATEUR DE DOHERTY DOTÉ D'UN COMBINEUR DE PUISSANCE EN PHASE À LARGE BANDE

(43) Date of publication of application: 23.11.2016
(73) Proprietor: Aselsan Elektronik Sanayi Ve Ticaret Anonim Sirketi, 06800 Ankara (TR)
(72) Inventor: UZUNOGLU, Erkan, 06800 Ankara (TR); YILMAZ, Ismail Gokhan, 06800 Ankara (TR)
(74) Representative: Yamankaradeniz, Kemal
(86) International application number: PCT/TR2014/000007
(87) International publication number: WO 2015/108492

(56) References cited:
- WO-A1-2013/133215
- ERCAN KAYMAKSUT ET AL: "Transformer-Based Uneven Doherty Power Amplifier in 90 nm CMOS for WLAN Applications", IEEE JOURNAL OF SOLID-STATE CIRCUITS, IEEE SERVICE CENTER, PISCATAWAY, NJ, USA, vol. 47, no. 7, 21 June 2012 (2012-06-21), pages 1659-1671, XP011448452, ISSN: 0018-9200, DOI: 10.1109/JSSC.2012.2191334
- OZIS D ET AL: "Integrated Quadrature Couplers and Their Application in Image-Reject Receivers", IEEE JOURNAL OF SOLID-STATE CIRCUITS, IEEE SERVICE CENTER, PISCATAWAY, NJ, USA, vol. 44, no. 5, 1 May 2009 (2009-05-01), pages 1464-1476, XP011256778, ISSN: 0018-9200, DOI: 10.1109/JSSC.2009.2016705

## Description

### Field of the Invention

The present invention relates to RF amplifiers and more specifically to Doherty amplifiers. This amplifier provides a wideband and compact impedance inverting and power combining network to improve the amplifier efficiency when handling a signal with a high peak-to-average ratio.

### Background of the Invention

Modern wireless communications systems providing higher data rates require wide bandwidths. So, the applied modulation and multiplexing schemas such as Wideband Code Division Multiple Access (WCDMA), Orthogonal Frequency Division Multiplexing (OFDM) perform high peak to average ratio signals in order to keep spectral efficiency. The typical peak to average ratio of the signals in 3G and 4G Long Term Evolution (LTE) systems ranges from 6dB to 10dB.

The RF power amplifiers used in wireless communication systems are required to have higher efficiency and linearity to handle such a high peak to average ratio signal. As generally there is a trade-off between the efficiency and linearity, RF power amplifiers perform the higher efficiency at the saturation level but distort the input signal with high non-linearity. At low power level which is called back-off level, linearity becomes easier but efficiency decreases. In order to get high efficiency at back-off level while maintaining linearity, the load of the amplifier can be changed dynamically according to the level of the input signal, which defined as load modulation.

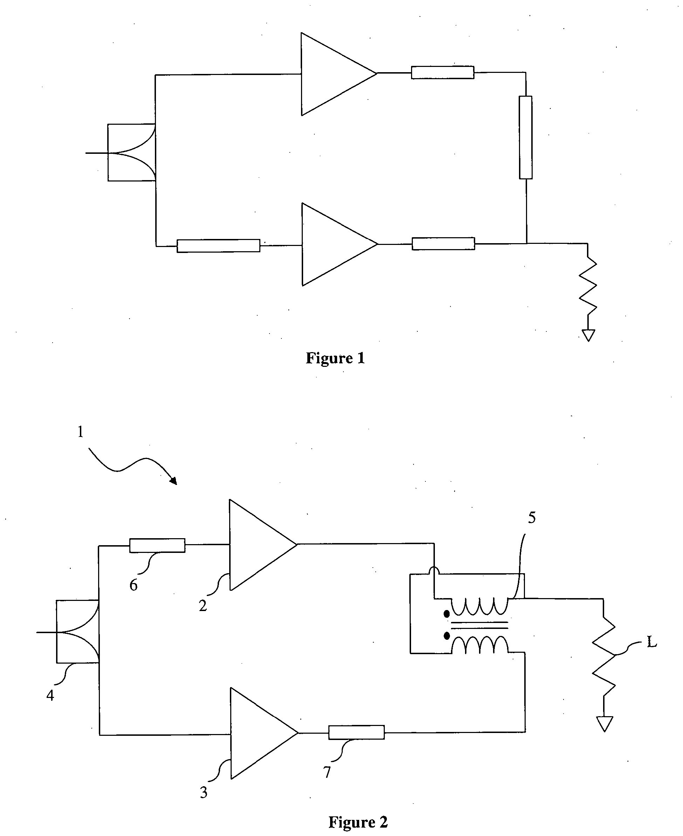

Doherty amplifier, which was first proposed by W.H. Doherty in 1936, is widely used in modern wireless communication systems with higher efficiency and moderate linearity. Figure 1 illustrates the structure of the conventional Doherty amplifier which consists of main and auxiliary amplifiers, input power divider, input and output offset lines and an impedance inverting network. The main amplifier is also defined as carrier amplifier and biased at Class AB or B, and the auxiliary amplifier is also defined as peaking amplifier and biased at Class C. The load at the combining node is Ropt/2 where Ropt is the matched impedance of the main and auxiliary amplifiers for maximum power and efficiency.

Applied input signal is splitted by the input power divider. The main amplifier is fed directly from input power divider; whereas the auxiliary amplifier is connected via the input offset line. The input offset line length is adjusted for phase compensation with the main amplifier. The outputs of the main and auxiliary amplifiers are combined to the load via the output offset lines and the impedance inverting network. At low power levels, only main amplifier is in operation and the auxiliary amplifier is non-conductive and present high impedance in ideal conditions. But in practice, with the effect of the package parasitic and matching elements the non-conductive output impedance of the auxiliary amplifier shifts. Therefore an output offset line is line required in order to have high impedance at the combining node when the auxiliary amplifier is non-conductive. The output offset line of the main amplifier has the same length with the auxiliary output offset line for phase coherence. The impedance inverting network is configured using a quarter-wavelength line with characteristic impedance of Ropt. For low power levels, the impedance inverting network converts the load impedance Ropt/2 to 2Ropt. When presented with 2Ropt load impedance, main amplifier reaches saturation at a power level lower than the rated peak power. This low power level where a peak efficiency point is achieved is defined as 6 dB back-off level for a 2-way symmetrical Doherty amplifier.

As the power level increases, the auxiliary amplifier starts to conduct and the supplied current from the auxiliary amplifier modulates the load seen by the main amplifier. The current contribution of the auxiliary amplifier increases the voltage on the load Ropt/2, which results in a decrease of the impedance seen by main amplifier with the impedance inverting operation of the quarter-wavelength impedance inverter. As the input signal is increased further both amplifiers will be presented with Ropt and maximum combined power with maximum efficiency is obtained.

European patent document EP2634916 discloses a Doherty amplifier is operable to receive an input signal (Pin) and to provide an amplified output signal (Pout) at an amplifier output. The Doherty amplifier comprises: first and second amplifier stages, each amplifier stage being switchable between an amplifying and a non-amplifying state, each amplifier stage being arranged in parallel to receive the input signal (Pin) and, in the amplifying state, to provide a respective amplified signal at a respective amplifier stage output; and an output network comprising first and second impedance transformers, each impedance transformer being coupled at a first side with a respective amplifier stage output and being coupled together in parallel at a second side with the amplifier output. By using an alternative, parallel architecture, the impedance transformation ratio experienced by an amplified signal under different operating conditions is significantly reduced compared to that of a traditional architecture which uses a single, series, impedance transformer which combines and transforms the amplified signals from both amplifier stages. Document WO 2013/133215 A1 discloses another Doherty amplifier of the prior art.

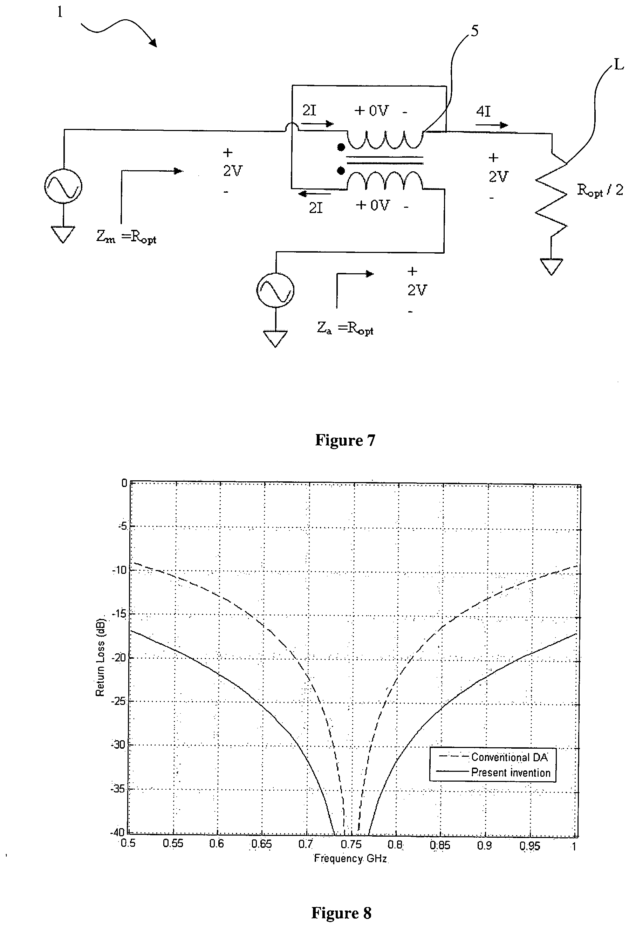

Conventional Doherty amplifiers use quarter-wavelength transmission line as for the impedance transforming or inverting network. This quarter-wavelength transmission line has inherently limited bandwidths. The frequency characteristics of a quarter-wavelength transmission line while inverting the impedance from Ropt/2 to 2Ropt is shown in Figure 8 with dashed line. If the -20dB return loss line is considered as a reference for operational bandwidth, the quarter-wavelength transmission lines have approximately 17 % frequency bandwidth. For operation at low frequencies, the physical size of the quarter-wavelength transmission lines becomes too large for the Doherty amplifier implementation.

### Summary of the Invention

Objective of the present invention is to obtain a wideband Doherty amplifier which provides a wideband and compact impedance inverting and power combining network to improve the amplifier efficiency when handling a signal with a high peak-to-average ratio.

### Brief Description of Contents

A Doherty amplifier realized to fulfill the objective of the present invention is illustrated in the accompanying figures, in which:
**Figure 1** is a schematic view of the conventional Doherty amplifier.
**Figure 2** is a schematic view of the Doherty amplifier with a wideband in-phase power combiner.
**Figure 3** is a schematic view of another configuration of Doherty amplifier with a wideband in-phase power combiner.
**Figure 4** is a schematic view of the schematic diagram of the transformer based output combiner.
**Figure 5** is a schematic view of another configuration of the transformer based output combiner.
**Figure 6** is a schematic view of the circuit analysis of the transformer based output combiner in terms of the voltages, currents and impedances at back-off level.
**Figure 7** is a schematic view of the circuit analysis of the transformer based output combiner in terms of the voltages, currents and impedances at full power level.
**Figure 8** is the frequency characteristics of the conventional Doherty amplifier and the present invention in terms of the return-loss at the output of the main amplifier, where the reference impedance is 2Ropt at back-off level.

Elements shown in the figures are numbered as follows:
- 1.: Doherty Amplifier with a wideband in-phase power combiner (Doherty Amplifier)
- 2.: Main amplifier
- 3.: Auxiliary amplifier
- 4.: Input power divider
- 5.: Transformer based combiner (Transformer)
- 6.: Input Transmission line
- 7.: Output Transmission line
- L.: Load
- O.: Transmission line
- C.: 90-degree input coupler

The Doherty amplifier (1) with a wideband in-phase power combiner may comprise:
- at least one main amplifier (2) which is also defined as carrier amplifier,
- at least one auxiliary amplifier (3) which is also defined as peaking amplifier,
- at least one input power divider (4) which splits the input signal,
- at least one transformer based combiner (5) which performs a 4:1 impedance transformation at back-off levels and an in-phase parallel power combiner at full power level,
- at least one input transmission line (6) which provides phase equalization of the main amplifier (2) and auxiliary amplifier (3) paths,
- at least one output transmission line (7) which provides low impedance at the termination node of the transformer based combiner (5) at back-off level.

### Detailed Description of the Invention

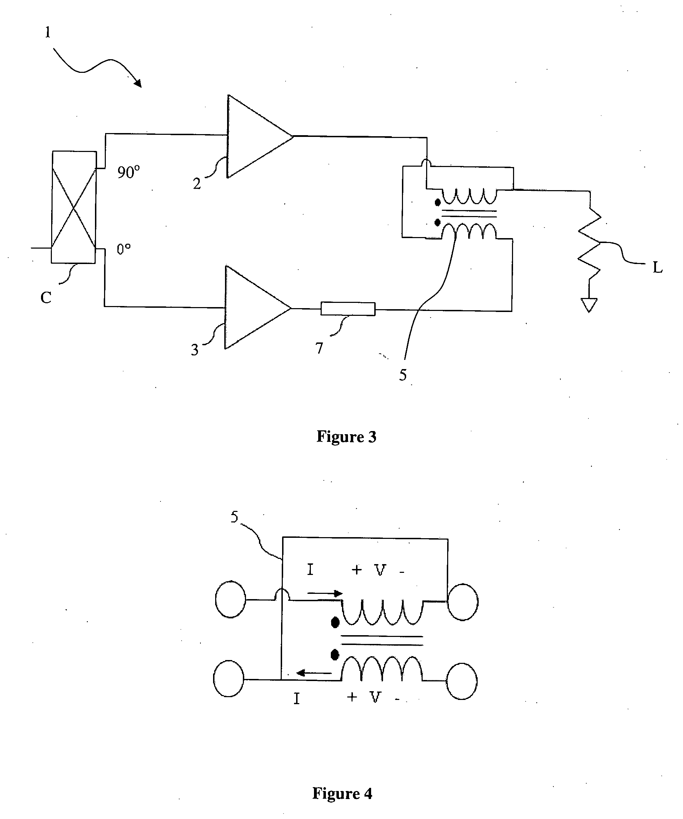

Before discussing the details of the invention, it will be useful to give a brief explanation of the transformer based output combiner (5). Figure 4 shows a 1:1 transformer (5) with port numbers 1-4 and also shows dot conventions with two dots at ports 1 and 3. Ports 1, 2 can be considered as primary side and ports 3, 4 can be considered as secondary side or vice-versa. Basically, a 1:1 transformer (5) consists of two windings linked by a mutual magnetic field. When an ac signal applied to one winding, a varying flux is developed and the mutual flux linked to the secondary winding induces a voltage whose amplitude and phase are same ideally. So, the voltage at the dotted end of the primary winding has the same amplitude and phase with the voltage at the dotted end of the secondary winding, with respect to the un-dotted ends of the both windings in a 1:1 transformer (5). Also, the currents at the dotted ends of the windings flow in reverse direction, as called differential. 1:1 transformers (5) can be implemented with several ways, such as parallel or twisted-pair lines, coaxial transmission lines, two sided micro strip lines on printed circuit boards, strip lines or etc. There are also commercially available transformers (5) in the industry. The operation bandwidth of the implemented transformers (5) is extended to low frequencies with loading an appropriate ferromagnetic material. In HF, VHF and UHF frequency bands, coaxial transmission lines are widely used as a 1:1 transformer (5) with the inner and outer conductors assigned as primary and secondary windings. In order to obtain a transformer (5) characteristic, the total length of the coaxial transmission line must be smaller than λ/8, where λ is the wavelength of the maximum frequency of the operation bandwidth. The operational frequency bandwidth of the practical 1:1 transformers (5) ranges from one octave up to one decade depending on the implementation methods.

The Doherty amplifier (1) with a wideband in-phase power combiner essentially comprises one main amplifier (2) which is also defined as carrier amplifier, one auxiliary amplifier (3) which is also defined as peaking amplifier, one input power divider (4) which splits the input signal, one transformer based combiner (5) which performs a 4:1 impedance transformation at back-off levels and an in-phase parallel power combiner at full power level, one input transmission line (6) which provides phase equalization of the main amplifier (2) and auxiliary amplifier (3) paths,, one output transmission line (7) which provides low impedance at the termination node of the transformer based combiner (5) at back-off level.

The Doherty amplifier (1) with a wideband in-phase power combiner provides a wideband and compact impedance inverting and power combining network to improve the amplifier efficiency when handling signal with a high peak-to-average ratio. The wideband and compact impedance inverting and power combining network utilizes an in-phase wideband power combiner, which is implemented with a cross connection between the dotted end of the one winding and the un-dotted end of the other winding of a 1:1 transformer (5) (Figure 3). The cross connected node of the transformer (5) is connected to the load (L) and the other two nodes are connected alternately to the main amplifier (2) and auxiliary amplifier (3) paths, as the structure is symmetrical referring to the load (L) connection. An output transmission line (7) is placed between the output of the auxiliary amplifier (3) and the transformer (5) node in order to provide low impedance at the termination node, while the auxiliary amplifier (3) is non-conductive at back-off level. The transformer-based output combiner performs a 4:1 impedance transformation at back-off levels and an in-phase parallel power combiner at full power level. The transformer-based output combiner structure has significant advantages such as wide operational bandwidth and compact size implementation for low frequency operation.

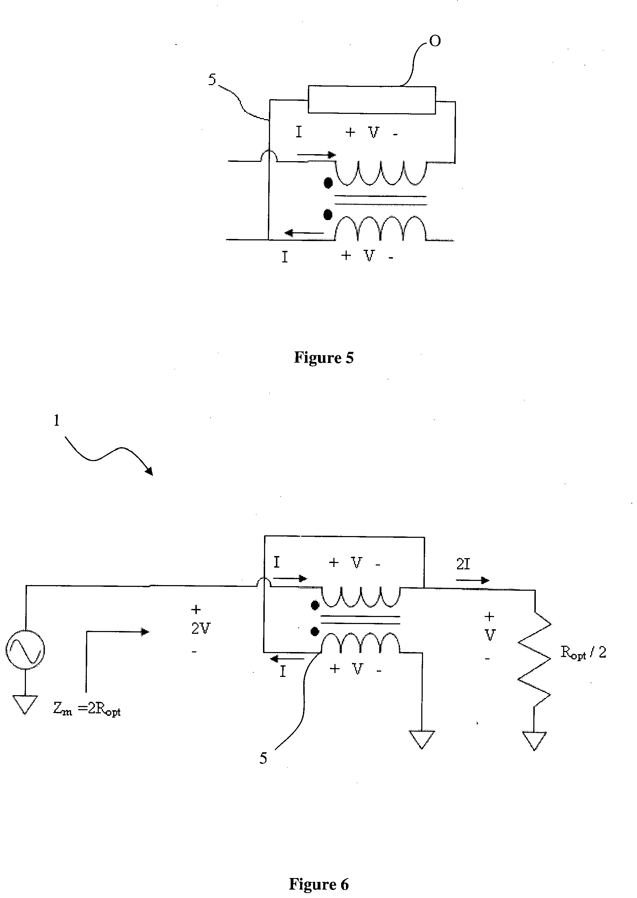

The output combiner of the Doherty amplifier (1) with a wideband in-phase power combiner is implemented with a cross connection from the dotted end of the one winding to the un-dotted end of the other winding of the transformer (5) (Figure 4). For the higher frequencies of the operation bandwidth, where the phase shift of the transformer (5) is considerably large, the cross connection should be implemented with a transmission line (O) (Figure 5). The length and the characteristics impedance of the transmission line (O) must be same with the transformer (5) for phase compensation. The cross connected port of the transformer (5) is connected to the load (L) and the other ports are connected to the main amplifier (2) and auxiliary amplifiers (3) outputs.

In the preferred embodiment, Doherty amplifier (1) with a wideband in-phase power combiner includes main amplifier (2) which can be biased at Class AB or at Class B. Doherty amplifier with a wideband in-phase power combiner (1) includes auxiliary amplifier (3) which can be biased at Class C. The auxiliary amplifier (3) is selectively operable for the higher portion of the input signal, while the main amplifier (2) is conductive for the full portion of the input signal. Generally, the bias level of the auxiliary amplifier (3) is adjusted to conduct where the main amplifier (2) reaches saturation at the 6 dB back-off level for a symmetrical Doherty amplifier (1). According to the efficiency, gain and linearity requirements of the Doherty amplifier (1), the bias level of the auxiliary amplifier (3) can be reconfigured.

In the preferred embodiment, the load (L) of a wideband Doherty amplifier (1) is at the cross-connected node of the transformer based combiner (5) and the load (L) impedance is Ropt/2 where Ropt is the matched impedance of the main amplifier (2) and auxiliary amplifiers (3) for maximum power and efficiency. The input transmission line (6) and output transmission line (7) are phase shifting elements with characteristics impedance of Ropt. The input transmission line (6) and output transmission line (7) can be replaced by equivalent lumped-element components.

In the preferred embodiment, Doherty amplifier (1) with a wideband in-phase power combiner includes the input power divider (4). The input power division can be observed either as equally or unequally. This choice depends on the efficiency, gain and linearity requirements of the Doherty amplifier (1) with a wideband in-phase power combiner. The auxiliary amplifier (3) is fed directly from input power divider (4); whereas the main amplifier (2) is connected via the input transmission line (6). The length of the input transmission line (6) is adjusted for phase equalization of the amplifier paths. The output of the main amplifier (2) is directly connected to the dotted end of the transformer based combiner (5). The output transmission line (7) is placed between the output of the auxiliary amplifier (3) and the un-dotted end of the transformer based combiner (5) in order to provide low impedance at the termination node, while the auxiliary amplifier (3) is non-conductive at back-off level.

At low power levels, only main amplifier (2) is in operation and the auxiliary amplifier (3) is non-conductive and presents an open circuit to the input of the output transmission line (7) in ideal conditions. A quarter-wavelength output transmission line (7) inverts the impedance to a short circuit being presented to un-dotted end of transformer based combiner (5). So, the auxiliary amplifier (3) is effectively decoupled in the non-conductive state.

Figure 6 illustrates the voltages, currents and the impedance seen by the main amplifier (2) Zm, at back-off level, when the un-dotted end of the transformer (5) is terminated with short circuit. The load (L) is Ropt/2 and the characteristics impedance of the transformer is Ropt, where Ropt is the matched impedance of the main amplifier (2) and auxiliary amplifier (3) for maximum power and efficiency. The winding which the main amplifier (2) connected to is defined as primary and the other winding is called as secondary. At back-off level the voltage on the secondary winding is equal to the voltage on the output load (L) (Figure 6). Moreover the primary and the secondary windings have the same voltage for a 1:1 transformer (5). It is obvious that the voltage at the output of the main amplifier (2) is equal to sum of the load (L) voltage and the primary winding voltage which is 2 times of the load (L) voltage. When an ac current of I is applied to the primary winding from the main amplifier (2), a current of the same magnitude flows out in reverse direction at the secondary winding. These two ac currents are summed at the output port and flow into the load (L). So a current twice as of the main amplifier (2) is supplied to the load (L). Considering the load (L) voltage that is half of the main amplifier's (2) output and twice the current, a 1:4 impedance conversion is obtained between the load (L) and the main amplifier (2) output at back-off level. As the load (L) impedance is chosen to be Ropt/2, main amplifier (2) is presented with 2Ropt impedance. Under this impedance condition main amplifier (2) operates with a similar higher efficiency and reaches saturation at a power level which is approximately 6 dB lower than the rated peak power delivered to the load.

When the input signal level is increased to where the main amplifier (2) reaches saturation, the auxiliary amplifier (3) is allowed to conduct, thus contributing voltage to the combiner node. As the voltage supplied from the auxiliary amplifier (3) increases which results in a decrease at the voltages of primary and secondary windings, voltage and current of the load (L) increases accordingly. Since the current flowing on the secondary winding is increasing with contribution from the auxiliary amplifier (3), the current flowing on the primary winding connected to main amplifier (2) is increasing in the same fashion. During this state the main amplifier (2) is kept in a voltage-saturated condition which leads to a decrease in impedance presented with the increase in current. So, the load impedance seen by the main amplifier (2) output is controlled by the load modulation effect of the auxiliary amplifier (3). Moreover the power level of this saturated condition of the main amplifier (2) continues to increase due to the decrease in the impedance presented to main amplifier (2) output. At the same time, the auxiliary amplifier (3) is contributing power to the load (L). As the input signal is increased further, the auxiliary amplifier (3) output voltage also reaches saturation level which causes the transformer (5) winding voltages to decreases to zero (Figure 7). Therefore, the voltage on the load (L) equals to the saturated voltages of the main amplifier (2) and auxiliary amplifier (3) and the current is two times greater. A parallel combination of the main amplifier (2) and auxiliary amplifier (3) is achieved at full power level. So, the main amplifier (2) and the auxiliary amplifier (3) are presented with Ropt and maximum combined power with maximum efficiency is obtained.

In the alternative embodiment, Doherty amplifier (1) with a wideband in-phase power combiner has another configuration. A 90-degree input coupler (C) is utilized in place of the input power divider (4) and the input transmission line (6) (Figure 3). This configuration is applicable when the phase shift of the input transmission line (6) is 90-degrees.

Doherty amplifier (1) differs from a classical Class AB amplifier with providing higher efficiency at back-off power levels. Therefore, the back-off efficiency should be considered as bandwidth criteria for Doherty amplifiers (1). Since, at full output power level, as the main and auxiliary paths are combined with phase coherency, the bandwidth of the Doherty amplifier (1) is limited only with the frequency characteristics of the main amplifier (2) and auxiliary amplifier (3). The back-off efficiency depends on the impedance presented at the output of the main amplifier (2). As 2Ropt is considered as the reference impedance for the back-off efficiency of a two way symmetrical Doherty amplifier (1), the impedance deviations from 2Ropt with the operating frequency will determine the bandwidth of the Doherty amplifier (1) with a wideband in-phase power combiner.

Figure 8 illustrates the frequency characteristics of the conventional Doherty amplifier and the Doherty amplifier (1) with a wideband in-phase power combiner in terms of the return-loss at the output of the main amplifier (2), where the reference impedance is 2Ropt at back-off level. For the frequency analysis, an octave frequency band from 0.5 GHz to 1 GHz is selected. Auxiliary amplifiers (3) both at the conventional Doherty amplifier and the Doherty amplifier (1) with a wideband in-phase power combiner are non-conductive and present ideally open circuit impedance. The quarter-wavelength input transmission line (6) and output transmission line (7) have a center frequency of 0.75 GHz. If the -20 dB return loss line is considered as a reference for operation bandwidth, the conventional Doherty amplifier has approximately 17 % frequency bandwidth as shown with a dashed line in Figure 8. On the other hand, the Doherty amplifier (1) with a wideband in-phase power combiner has two times greater (approximately 47 %) frequency bandwidth as shown with a solid line in Figure 8. Considering the package parasitic and the matching circuits, in some cases the auxiliary amplifier (3) presents low impedance at back-off level. Due to the phase shifting function of the matching circuits, the transistor level high impedance of the auxiliary amplifier (3) may be inverted to low impedance at non-conductive state. Under this condition, the auxiliary amplifier (3) output can be connected directly to the transformer based combiner (5), which results in a compact design without input transmission line (6) and output transmission line (7). Accordingly, with this configuration an extended operational bandwidth can be achievable depending on the frequency bandwidth characteristics of the main amplifier (2) and auxiliary amplifier (3).

## Claims

1. A Doherty amplifier (1) comprising:
- at least one main amplifier (2)
- at least one auxiliary amplifier (3)
- at least one input power divider (4) for splitting an input signal,
- at least one transformer based combiner (5), at least one input transmission line (6) which is connected between the input power divider (4) and the main amplifier (2),
- at least one output transmission line (7) which is connected between an output of the auxiliary amplifier (3) and the transformer based combiner (5)and **characterized by**
- the transformer based combiner (5) being a 1:1 transformer with a winding having a dotted end and an un-dotted end, and with another winding having a dotted end and an un-dotted end, the Doherty amplifier (1) further comprising a wideband in-phase power combiner which is implemented with a single cross connection between the dotted end of the winding and the un-dotted end of the other winding as cross connected nodes, wherein the cross connected nodes of the transformer (5) are connected to a load (L), the dotted end of the other winding being a node which is connected to an output of the main amplifier (2) and the un-dotted end of the winding being a node which is connected to the output of the auxiliary amplifier (3) via the at least one output transmission line (7).

2. The Doherty amplifier according to claim 1 wherein the main amplifier (2) is configured to be biased at Class AB.

3. The Doherty amplifier according to claim 1 wherein the main amplifier (2) is configured to be biased at Class B.

4. The Doherty amplifier according to claim 1 wherein the auxiliary amplifier (3) is configured to be biased at Class C.

5. The Doherty amplifier according to claim 1 wherein the auxiliary amplifier (3) is directly connected from its input to one of the outputs of the input power divider (4).

6. The Doherty amplifier according to claim 1 wherein the input transmission line (6) has a length that provides phase equalization of amplification paths of the main amplifier (2) and the auxiliary amplifier (3).

7. The Doherty amplifier according to claim 1 wherein the auxiliary amplifier (3) is configured to be non-conductive at back-off levels.

## Patentansprüche

1. Doherty-Verstärker (1), umfassend:
mindestens einen Hauptverstärker (2), mindestens einen Nebenverstärker (3), mindestens einen Eingangsleistungsteiler (4) zum Teilen eines Eingangssignals, mindestens einen Kombinierer (5) auf Transformatorbasis, mindestens eine Eingangsübertragungsleitung (6), die zwischen dem Eingangsleistungsteiler (4) und dem Hauptverstärker (2) verbunden ist, mindestens eine Ausgangsübertragungsleitung (7), die zwischen einem Ausgang des Hilfsverstärkers (3) und dem Kombinierer (5) auf Transformatorbasis verbunden ist, und **dadurch gekennzeichnet, dass** der Kombinierer (5) auf Transformatorbasis ein 1:1-Transformator mit einer Wicklung ist, die ein punktiertes Ende und ein nicht punktiertes Ende aufweist, und mit einer anderen Wicklung, die ein punktiertes Ende und ein nicht punktiertes Ende aufweist, wobei der Doherty-Verstärker (1) ferner einen gleichphasigen Breitband-Leistungskombinierer umfasst, der mit einer einzelnen Querverbindung zwischen dem punktierten Ende der Wicklung und dem nicht punktierten Ende der anderen Wicklung als querverbundene Knoten umgesetzt ist, wobei die querverbundenen Knoten des Transformators (5) mit einer Last (L) verbunden sind, wobei das punktierte Ende der anderen Wicklung ein Knoten ist, der mit einem Ausgang des Hauptverstärkers (2) verbunden ist und das nicht punktierte Ende der Wicklung ein Knoten ist, der mit dem Ausgang des Nebenverstärkers (3) über die mindestens eine Ausgangsübertragungsleitung (7) verbunden ist.

2. Doherty-Verstärker nach Anspruch 1, wobei der Hauptverstärker (2) dazu konfiguriert ist, an Klasse AB vorgespannt zu sein.

3. Doherty-Verstärker nach Anspruch 1, wobei der Hauptverstärker (2) dazu konfiguriert ist, an Klasse B vorgespannt zu sein.

4. Doherty-Verstärker nach Anspruch 1, wobei der Nebenverstärker (3) dazu konfiguriert ist, an Klasse C vorgespannt zu sein.

5. Doherty-Verstärker nach Anspruch 1, wobei der Nebenverstärker (3) direkt von seinem Eingang mit einem der Ausgänge des Eingangsleistungsteilers (4) verbunden ist.

6. Doherty-Verstärker nach Anspruch 1, wobei die Eingangsübertragungsleitung (6) eine Länge aufweist, die einen Phasenausgleich von Verstärkungspfaden des Hauptverstärkers (2) und des Nebenverstärkers (3) bereitstellt.

7. Doherty-Verstärker nach Anspruch 1, wobei der Nebenverstärker (3) dazu konfiguriert ist, an Back-Off-Ebenen nicht leitfähig zu sein.

## Revendications

1. Amplificateur Doherty (1) comprenant :
- au moins un amplificateur principal (2),
- au moins un amplificateur auxiliaire (3),
- au moins un répartiteur de puissance d'entrée (4) pour diviser un signal d'entrée,
- au moins un combineur basé sur transformateur (5), au moins une ligne de transmission d'entrée (6) qui est connectée entre le répartiteur de puissance d'entrée (4) et l'amplificateur principal (2),
- au moins une ligne de transmission de sortie (7) qui est connectée entre une sortie de l'amplificateur auxiliaire (3) et le combineur basé sur transformateur (5) et **caractérisé en ce que**
- le combineur basé sur transformateur (5) est un transformateur 1:1 doté d'un enroulement possédant une extrémité pointillée et une extrémité non pointillée, et doté d'un autre enroulement possédant une extrémité pointillée et une extrémité non pointillée, l'amplificateur Doherty (1) comprenant en outre un combineur de puissance en phase à large bande qui est mis en oeuvre avec une seule connexion transversale entre l'extrémité pointillée de l'enroulement et l'extrémité non pointillée de l'autre enroulement sous forme de noeuds interconnectés, lesdits noeuds interconnectés du transformateur (5) étant connectés à une charge (L), l'extrémité pointillée de l'autre enroulement étant un noeud qui est connecté à une sortie de l'amplificateur principal (2) et l'extrémité non pointillée de l'enroulement étant un noeud qui est connecté à la sortie de l'amplificateur auxiliaire (3) via ladite au moins une ligne de transmission de sortie (7).

2. Amplificateur Doherty selon la revendication 1, ledit amplificateur principal (2) étant configuré pour être polarisé en classe AB.

3. Amplificateur Doherty selon la revendication 1, ledit amplificateur principal (2) étant configuré pour être polarisé en classe B.

4. Amplificateur Doherty selon la revendication 1, ledit amplificateur auxiliaire (3) étant configuré pour être polarisé en classe C.

5. Amplificateur Doherty selon la revendication 1, ledit amplificateur auxiliaire (3) étant connecté directement de son entrée à l'une des sorties du répartiteur de puissance d'entrée (4).

6. Amplificateur Doherty selon la revendication 1, ladite ligne de transmission d'entrée (6) ayant une longueur qui assure l'égalisation de phase des voies d'amplification de l'amplificateur principal (2) et de l'amplificateur auxiliaire (3).

7. Amplificateur Doherty selon la revendication 1, ledit amplificateur auxiliaire (3) étant configuré pour être non conducteur à des niveaux de réduction de puissance.
